# EUROPEAN PATENT APPLICATION

(11) **EP 2 172 784 A1**
(43) Date of publication of application: **07.04.2010**
(21) Application number: 08790267.2
(22) Date of filing: 28.07.2008
(51) Int. Cl.: G01R 19/00

(54) **VOLTAGE DETECTING DEVICE AND POWER SUPPLY SYSTEM USING THE SAME**

(30) Priority: 09.08.2007 JP 2007207589
(71) Applicant: Panasonic Corporation, Kadoma-shi Osaka 571-8501 (JP)
(72) Inventor: MORIMOTO, Naohisa, Osaka-shi, Osaka 540-6207 (JP)
(74) Representative: Schwabe - Sandmair - Marx
(86) International application number: PCT/JP2008/002003
(87) International publication number: WO 2009/019825

(57) **Abstract**

A voltage detection device has: a differential voltage detection circuit, which detects a potential difference across a pair of input terminals; a multiplexer which selects two electrode terminals among electrode terminals of a plurality of series-connected battery modules, and has a sampling switch for respectively connecting the two selected electrode terminals to first and second wiring lines; a flying capacitor circuit, which acquires a voltage across the first and second wiring lines, and outputs the voltage to the pair of input terminals; and a signal generator, which applies common-mode noise to the flying capacitor circuit.

## Description

### Technical Field

The present invention relates to a voltage detection device of a plurality of series-connected battery modules, and to a power supply system using such a voltage detection device.

### Background Art

In recent years, hybrid automobiles, which employ both engines and electric motors, have come into widespread use, and there is also expanding use of fuel cell vehicles and other electric automobiles. Such vehicles which use an electric motor as a driving power source have a high-voltage power supply for motor driving, and in order to prevent shocks to a user who touches the high-voltage power supply portion, an insulating structure is employed between the high-voltage power supply and the vehicle body.

Hence due to stray capacitances and other differences between the inverter, wiring, motor interior and vehicle body during motor operation, the potential of the high-voltage power supply portion fluctuates greatly relative to the vehicle body in common mode.

Hence in hybrid vehicles, fuel cell vehicles and similar, a flying capacitor circuit with excellent common-mode noise immunity characteristics are widely used for monitoring the voltage of secondary batteries forming high-voltage power supplies.

In flying capacitor circuits which monitor high-voltage power supplies, methods are known for detecting malfunctions of the multiplexer portion when the detected voltage is a prescribed anomalous value or similar (see for example Patent Document 1 and Patent Document 2), and for judging defective operation through the fractional change in the output voltage when the multiplexer turn-on time is changed (see for example Patent Document 3).

However, in the above-described methods of malfunction diagnosis of a flying capacitor circuit, circuit direct current voltage precision malfunctions can be detected, but diagnosis of the immunity of common-mode noise occurring upon changes in the stray capacitances of the wiring of the inverter driving the motor, the motor interior, and the vehicle body, cannot be adequately performed. When common-mode noise immunity of a flying capacitor circuit declines, the precision of voltage detection of secondary batteries comprised by the high-voltage power supply declines, and there are concerns that secondary battery malfunction detection and other erroneous diagnoses may result. As a consequence, it may not be possible to take subsequent appropriate measures, service characteristics may be worsened, and other problems may occur.
Patent Document 1: Japanese Patent Application Laid-open No. 2002-281681
Patent Document 2: Japanese Patent Application Laid-open No. 2003-84015
Patent Document 3: Japanese Patent Application Laid-open No. 2004-245743

### Disclosure of the Invention

Hence an object of this invention is to provide a voltage detection device using a flying capacitor which is capable of diagnosing common mode noise immunity performance, as well as a power supply system which uses such a device.

The voltage detection device of one aspect of the invention has: a differential voltage detection circuit, which detects a potential difference across a pair of input terminals; a multiplexer which selects two electrode terminals among electrode terminals of a plurality of series-connected battery modules, and has a sampling switch for respectively connecting the two selected electrode terminals to first and second wiring lines; a flying capacitor circuit, which acquires a voltage across the first and second wiring lines, and outputs the voltage to the pair of input terminals; and a signal generator, which applies common-mode noise to the flying capacitor circuit.

By means of this configuration, common-mode noise can be applied to the flying capacitor circuit by the signal generator, so that based on the voltage detected by the differential voltage detection circuit when common-mode noise is applied, the common-mode noise immunity performance can easily be diagnosed.

Further, the power supply system according to one aspect of the invention comprises the above-described voltage detection device, and a plurality of battery modules.

By means of this configuration, common-mode noise immunity performance can be diagnosed in a power supply system comprising a plurality of battery modules and a voltage detection device using a flying capacitor.

### Brief Description of the Drawings

[Fig. 1] Fig. 1 is a circuit diagram showing the voltage detection device and power supply system of one embodiment of the invention (Embodiment 1).
[Fig. 2A] Fig. 2A is a circuit diagram of a flying capacitor circuit and other circuitry.
[Fig. 2B] Fig. 2B is an explanatory diagram showing the operation sequence of a flying capacitor circuit.
[Figs. 3] Fig. 3A is a circuit diagram of a signal generator; and Fig. 3B is an explanatory diagram showing an example of operation of a signal generator.
[Figs. 4] Fig. 4A shows an example of the voltage output from a signal generator and the voltage input to a microcomputer; and Fig. 4B shows an example of the filter characteristics of a differential voltage detection circuit comprised by a flying capacitor circuit.
[Figs. 5] Fig. 5A shows an example of the voltage output from a signal generator and the voltage input to a microcomputer in a case in which the differential voltage detection circuit comprised by a flying capacitor circuit malfunctions; and Fig. 5B shows an example of filter characteristics when a differential voltage detection circuit malfunctions.
[Fig. 6] Fig. 6 is a circuit diagram showing the voltage detection device and power supply system of one embodiment of the invention (Embodiment 2).

### Best Mode for Carrying Out the Invention

A voltage detection device of the invention is characterized in having: a differential voltage detection circuit, which detects a potential difference across a pair of input terminals; a multiplexer has a sampling switch which connects electrode terminals of a plurality of series-connected battery modules to the input terminals of the differential voltage detection circuit respectively, a flying capacitor circuit, which connected between the multiplexer and the differential voltage detection circuit ; and a signal generator, which applies common-mode noise to the flying capacitor circuit.

A malfunction diagnostic device of a voltage detection circuit of the invention connects a signal generation device to a portion of the flying capacitor or to the input terminals of a differential amplification circuit, and by detecting changes in the output voltage of the differential amplification circuit through the input from the signal generator, can perform diagnosis of the common mode noise immunity performance.

Further, a voltage detection device of the invention may be configured with two or more flying capacitors series-connected in the flying capacitor circuit, and with the common-mode noise of the signal generator applied to the center point of the flying capacitor circuit.

Further, a voltage detection device of the invention may be configured with the common-mode noise of the signal generator applied to the input terminals of the differential voltage detection circuit.

### (Embodiment 1)

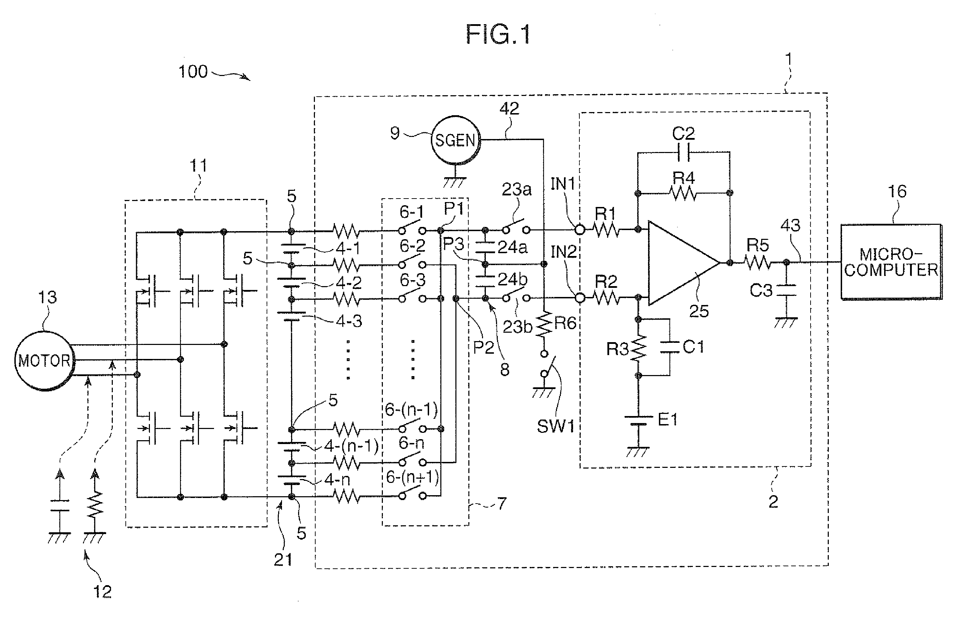

Below, embodiments of the invention are explained based on the drawings. In the drawings, constituent portions assigned the same symbols are the same constituent portions, and explanations thereof are omitted. Fig. 1 is a circuit diagram showing an example of the configurations of a voltage detection device comprising a flying capacitor circuit with signal generator device added, and a power supply system using this voltage detection device, in one embodiment of the invention.

The power supply system 100 shown in Fig. 1 comprises a secondary battery 21 and a voltage detection device 1. The voltage detection device 1 shown in Fig. 1 detects the voltage of the secondary battery 21, in which a plurality of battery modules, for example n battery modules 4-1 to 4-n, are series-connected.

The voltage detection device 1 comprises a multiplexer 7 having (n+1) sampling switches 6-1 to 6-(n+1), a flying capacitor circuit 8, a differential voltage detection circuit 2, and a signal generator 9 which applies common-mode noise to the flying capacitor circuit 8.

In the following explanation, when referring collectively to the battery modules 4-1 to 4-n and the sampling switches 6-1 to 6-(n+1), reference is made to battery modules 4 and sampling switches 6, with the subscript omitted; when indicating individual elements, reference symbols with subscripts are used.

A load is connected to the secondary battery 21. As the load, for example an inverter 11 to drive a motor and a motor 13 are connected, as shown in Fig. 1. The inverter 11 for motor driving is a circuit which drives a motor 13 to cause operation of, for example, a hybrid vehicle, fuel cell vehicle, or other electric vehicle. And, stray capacitance and ground resistance, such as indicated by the symbol 12, occur.

The stray capacitance and ground resistance indicated by the symbol 12 are the result of floating capacitive coupling to ground of windings in the motor, floating capacitive coupling to ground of wires supplying power to the motor, capacitance to ground of IGBTs (Insulated Gate Bipolar Transistors) comprised by the inverter, and similar.

Here, if the secondary battery 21 is insulated from ground (the vehicle body) in order to prevent shocks, the potential relative to ground of the secondary battery 21 is affected by the charging voltage of stray capacitance, and fluctuates due to common-mode noise occurring as a result of the motor induced voltage.

The battery modules 4-1 to 4-n each comprise a plurality of cells connected in series, in parallel, or combined in series and parallel. As cells, for example nickel hydrogen secondary batteries, lithium ion secondary batteries, or various other batteries can be used. By this means, for example the secondary battery 21 can be configured by connecting a plurality of 1.2 V nickel hydrogen secondary batteries, such as for example from 240 to 500 such batteries, in series, to output a high voltage of for example approximately 288 V to 600 V.

The flying capacitor circuit 8 is a circuit used to detect the terminal voltages of each of the battery modules 4-1 to 4-n in the secondary battery 21. The microcomputer 16 measures the voltage and capacitance of the secondary battery 21 and performs malfunction diagnostics and similar based on the output voltage of the flying capacitor circuit 8. The signal generator 9 is a signal generator device used to detect drops in the common-mode noise immunity of the flying capacitor circuit 8 and similar.

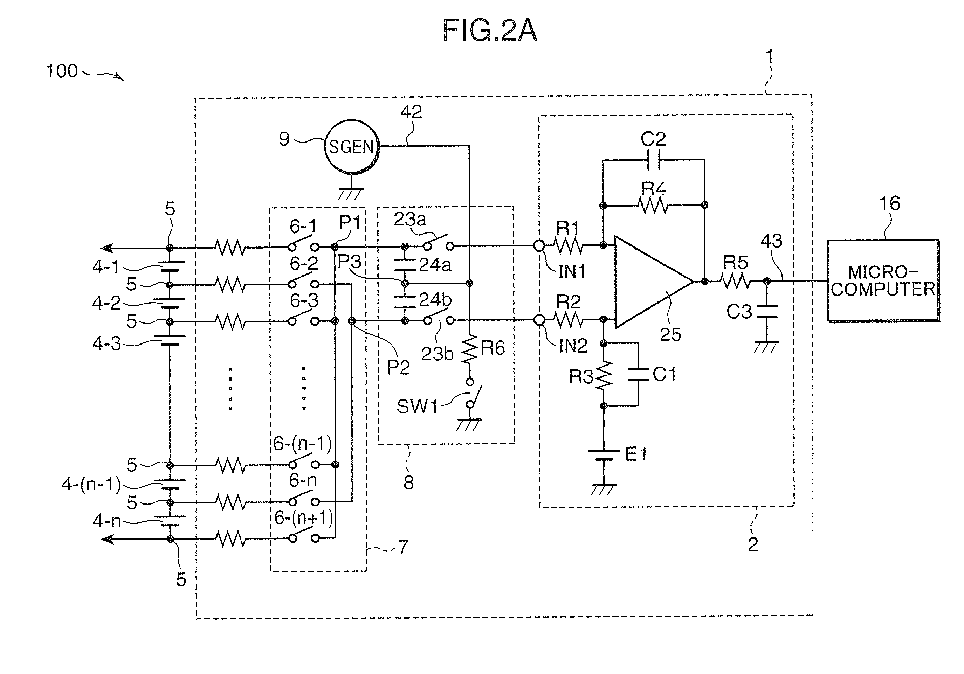

Fig. 2A is a circuit diagram showing one example of the configuration of the power supply system 100 shown in Fig. 1. The flying capacitor circuit 8 comprises capacitors 24a and 24b (flying capacitors), a switch 23a (first switching element), a switch 23b (second switching element), a switch SW1 (third switching element), and a resistor R6.

As the sampling switches 6-1 to 6-(n+1), switches 23a and 23b, and switch SW1, for example FETs (Field Effect Transistors) or various other switching elements can be used.

The capacitor 24a and the capacitor 24b are connected in series. And, the center point P3 which is the point of connection of the capacitor 24a and the capacitor 24b is connected to ground via the resistor R6 and switch SW1.

The capacitors used as flying capacitors are not limited to the two capacitors 24a and 24b, and three or more capacitors may be connected in series. In this case, a point substantially at the center of the plurality of series-connected flying capacitors is used as the center point P3.

The differential voltage detection circuit 2 comprises a differential amplification circuit 25, resistors R1 to R5, capacitors C1 to C3, a pair of input terminals IN1 and IN2, and a constant-voltage supply E1.

The battery modules 4-1 to 4-n each comprise electrode terminals at both ends. In Fig. 1, a negative electrode on one side and positive electrode on the other side between battery modules are together shown as electrode terminals 5. The positive electrode-side electrode terminals 5 of the battery modules 4-1 to 4-n are each connected to one end of a sampling switch 6-1 to 6-n via a resistor. The negative electrode-side electrode terminal 5 of the battery module 4-n is connected to one end of the sampling switch 6-(n+1) via a resistor.

And, the series circuit of the capacitor 24a and capacitor 24b is connected between t of each of the other ends of those sampling switches among the sampling switches 6-1 to 6-(n+1) with an odd-numbered subscript (odd-numbered sampling switches), and the connection point P2 of each of the other ends of those sampling switches among the sampling switches 6-1 to 6-(n+1) with an even-numbered subscript (even-numbered sampling switches). The connection point P1 is equivalent to the first wiring line or the second wiring line. The connection point P2 is equivalent to the second wiring line or the first wiring line

The connection point P1 is connected to one of the input terminals of the differential amplification circuit 25 via the switch 23a, input terminal IN1, and resistor R1. The connection point P2 is connected to the other input terminal of the differential amplification circuit 25 via the switch 23b, input terminal IN2, and resistor R2. And, a parallel circuit of the capacitor C2 and resistor R4 is connected between the output terminal of the differential amplification circuit 25 and the input terminal of the differential amplification circuit 25 connected to the resistor R1.

The input terminals IN1 and IN2 may for example be electrodes or connectors, and may for example be wiring patterns which are lands or pads of the resistors R1 and R2,or others.

Further, the input terminal of the differential amplification circuit 25 connected to the resistor R2 is connected to the constant-voltage supply E1 via the parallel circuit of the capacitor C1 and resistor R3. The constant-voltage supply E1 outputs a preset offset voltage Vs. The offset voltage Vs is set to for example 1/2 the input voltage range of an analog/digital converter comprised by the microcomputer 16; for example, when the input voltage range is 0 to 5 V, the offset voltage Vs is set to 2.5 V.

And, the output terminal of the differential amplification circuit 25 is connected to ground via the resistor R5 and capacitor C3. Further, the connection point of the resistor R5 and capacitor C3 is connected to the input terminal of the analog/digital converter comprised by the microcomputer 16. The voltage detection device 1 may also be configured comprising the microcomputer 16.

The microcomputer 16 comprises, for example, a CPU (Central Processing Unit) which executes prescribed computation processing; a nonvolatile ROM (Read Only Memory), in which a prescribed control program is stored; RAM (Random Access Memory) which temporarily stores data; the analog/digital converter; and peripheral circuitry and similar.

By executing the control program stored in ROM, the microcomputer 16 performs on/off control of the sampling switches 6-1 to 6-(n+1), switches 23a and 23b, and switch SW1, controls operation of the signal generator 9, and converts the voltage output from the differential amplification circuit 25 via the resistor R5 using the analog/digital converter to obtain a digital value. Further, the microcomputer 16 judges whether the common-mode noise immunity of the flying capacitor circuit 8 is abnormal, based on the signal voltage output from the differential amplification circuit 25. In this case, the microcomputer 16 is equivalent to an example of a control portion and judgment portion.

The switches 6 are selectively turned on and off by the microcomputer 16, and are switches which selectively copy the voltage of the secondary battery 21 to the capacitors 23. The switches 23 is switches to connect the capacitors 24 to the differential amplification circuit 25, and to detect the battery voltage of the secondary battery 21 selected by the microcomputer 16 using the switches 6; by turning the switches 6 and switches 23 on and off, the secondary battery 21 and differential amplification circuit 25 are not directly connected.

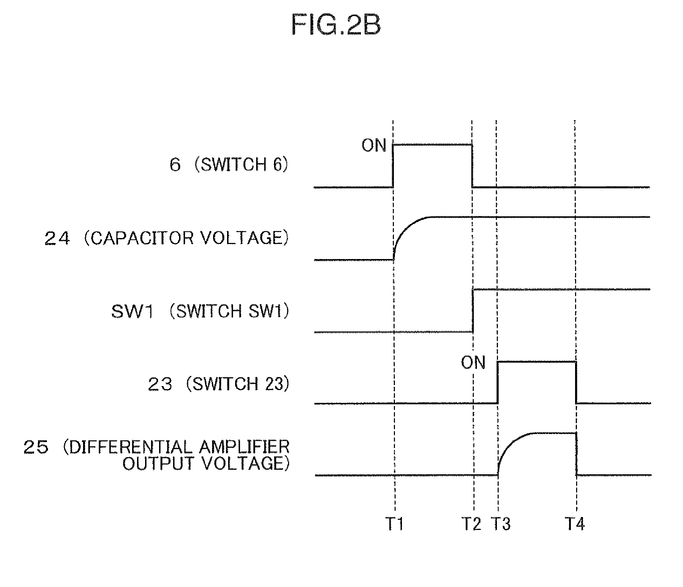

Fig. 2B is an explanatory diagram showing one example of the operation sequence of the flying capacitor circuit 8 shown in Fig. 2A. First, the microcomputer 16 selects a battery module 4 the terminal voltage of which is to be measured, turns on the two sampling switches 6 connected to the selected battery module 4 via resistors, and turns off the other sampling switches 6, switches 23a and 23b, and the switch SW1 (with timing T1). Then, the capacitors 24a and 24b are charged by the selected battery module 4.

At this time, the capacitors 24a and 24b are detached from the differential voltage detection circuit 2 by the switches 23a and 23b, and are detached from ground by the switch SW1, so that the potential relative to ground of the capacitors 24a, 24b is determined by the potentials relative to ground of the motor driving inverter 11 and secondary battery 21, and a difference occurs with the potential relative to ground of the differential voltage detection circuit 2, which is at ground potential via the power supply. Consequently if the charging voltage of the capacitors 24a, 24b is output without modification to the differential voltage detection circuit 2, a deviation occurs between the input voltage range of the differential voltage detection circuit 2 and the charging voltage, and there are concerns that the precision of voltage measurement may decline.

Hence after sufficient time has elapsed for the capacitors 24a, 24b to be charged and for the terminal voltage to assume a steady state, the microcomputer 16 turns off the sampling switches 6 connected to the selected battery module 4, and turns on the switch SW1 (with timing T2). Then, the center point P3 is connected to ground, and the charging voltage of the capacitors 24a and 24b, that is, the voltage across the connection points P1 and P2, is divided into substantially equal positive and negative portions centered on the ground potential.

Next, the microcomputer 16 turns on the switches 23a and 23b (timing T3). Then, the voltage charging the capacitors 24a and 24b, that is, the terminal voltage of the selected battery module 4, is applied across the differential input terminals of the differential amplification circuit 25 via the input terminals IN1 and IN2 and the resistors R1 and R2. Then, the voltage applied to the differential amplification circuit 25 is amplified by the differential amplification circuit 25, and is output to the microcomputer 16 as information indicating the terminal voltage of the selected battery module 4.

At this time, the voltage applied to the differential amplification circuit 25 is divided into substantially equal positive and negative portions centered on the ground potential, so that the input voltage range of the differential amplification circuit 25 can be effectively utilized to improve the precision of voltage detection.

Here, the polarity of the charging voltage charging the capacitors 24a, 24b is inverted when the terminal voltage of a battery module 4 with an odd-numbered subscript is detected, and when the terminal voltage of a battery module 4 with an even-numbered subscript is detected. Hence the voltage 43 input to the microcomputer 16 indicates the positive or negative voltage above or below the offset voltage Vs, and so the voltage polarity is arranged according to whether the subscript number of the battery module 4 the voltage of which is to be detected is odd or even.

When the terminal voltage of the selected battery module 4 is acquired by the microcomputer 16 in this way, the microcomputer 16 turns off the switches 23a, 23b used to measure the terminal voltage of the next battery module 4 (timing T4). And, the microcomputer 16 selects another battery module 4, and by again repeating the operations of timing T1 to T4, acquires the terminal voltage of the battery modules 4-1 to 4-n.

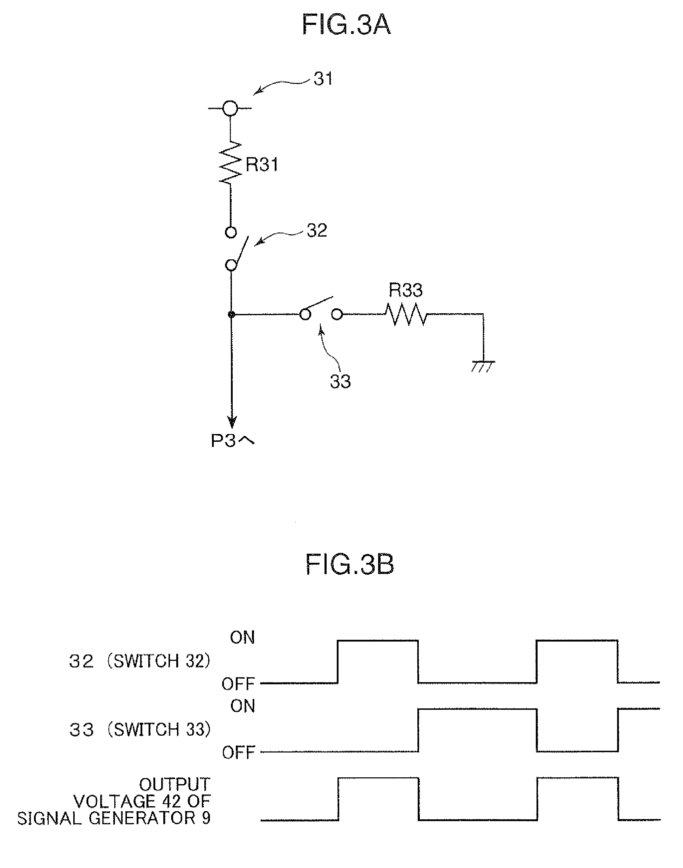

Fig. 3A is a circuit diagram showing an example of the signal generator shown in Fig. 1. In this example, the signal generator 9 comprises a power supply 31, switch 32, switch 33, resistor R31, and resistor R33. And, one end of the resistor R31 is connected to the power supply 31. Further, the switch 32, switch 33, and resistor R33 are connected in series from the other end of the resistor R31, and the other end of the resistor R33 is connected to ground. Also, the voltage at the connection point of the switch 32 and the switch 33 is applied to the center point P3 as the output voltage of the signal generator 9.

The power supply 31 supplies a preset voltage to the resistor R31. The voltage supplied by the power supply 31 may be 12 V, or may be 5 V.

Fig. 3B is an explanatory diagram showing an example of operation of the signal generator 9 shown in Fig. 1 and Fig. 2A. First, when the switch 32 is turned on, the output voltage 42 of the signal generator 9 becomes the voltage of the power supply 31, and when the switch 32 is turned off and the switch 33 is turned on, the output voltage 42 of the signal generator 9 becomes 0 V.

In this way, by using for example the microcomputer 16 and an oscillator circuit, not shown, and turning on and off the switch 32 and switch 33 with opposite phases at a preset frequency fs, the output voltage 42 with frequency fs is applied to the center point P3 as pseudo-common-mode noise. This application of common-mode noise is executed with the switch SW1 in the on state.

The output voltage 42 of the signal generator 9 is not limited to the square wave shown in Fig. 3B, and a sine wave, triangle wave, or various other signal waveforms can be used. And, the output voltage 42 of the signal generator 9 obtained in this way is applied to the center point P3 of the flying capacitor circuit 8. A configuration may also be employed in which a resistor R6 is not comprised, and instead, the switch SW1 is turned off and common-mode noise is applied.

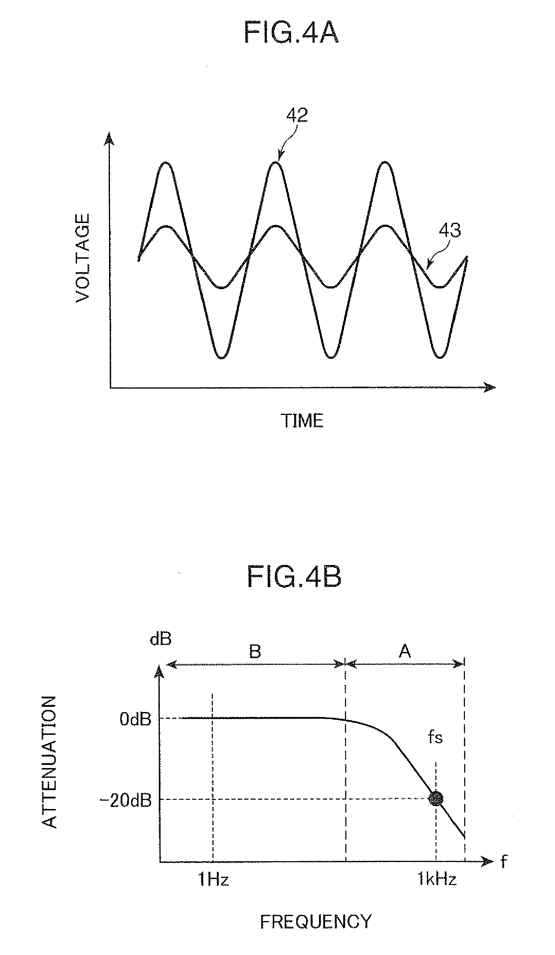

Fig. 4A shows an example of the voltage 42 output from the signal generator 9 and the voltage 43 input to the microcomputer 16. In Fig. 4A, an example is shown in which the voltage 42 is sinusoidal. Fig. 4B shows an example of the filter characteristics of the differential voltage detection circuit 2 comprised by the flying capacitor circuit.

For example, if as shown in Fig. 4B the filter characteristics of the differential voltage detection circuit 2 are 0 dB at 1 Hz and -20 dB at 1 kHz, then when the voltage 42 output from the signal generator 9 is a sine wave of frequency 1 Hz with a peak-to-peak voltage Vp-p of 5 V, the peak-to-peak voltage Vp-p of the voltage 43 input to the microcomputer 16 is 5 V.

Further, when the voltage 42 output from the signal generator 9 has a peak-to-peak voltage Vp-p of 5 V and frequency of 1 kHz, the peak-to-peak voltage Vp-p of the voltage 43 input to the microcomputer 16 is 0.5 V.

Hence by measuring the change in the peak-to-peak voltage Vp-p of the voltage 43, the microcomputer 16 can diagnose the common-mode noise immunity performance of the differential amplification circuit comprised by the flying capacitor circuit.

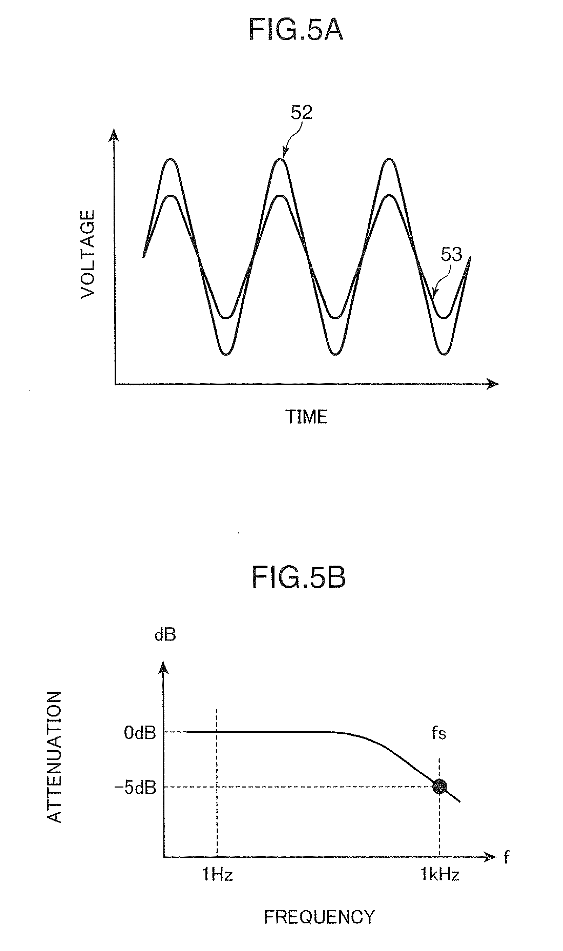

Fig. 5A shows an example of the voltage 52 output from the signal generator 9 and the voltage 53 input to the microcomputer 16, in a case in which the differential voltage detection circuit 2 comprised by the flying capacitor circuit has malfunctioned. Fig. 5B shows an example of filter characteristics in a case in which the differential voltage detection circuit 2 has malfunctioned. Fig. 5B shows a state in which, due to worsening of the filter characteristics of the operational amplifier circuit due to the malfunction, the Vp-p of the voltage 53 input to the microcomputer 16 rises without sufficient attenuation of the output voltage 53 of the signal generator 9.

For example, the filter characteristic shown in Fig. 4B changes to that shown in Fig. 5B due to malfunction, and when the attenuation amount at 1 kHz becomes -5 dB, if the voltage 52 output from the signal generator 9 is a sine wave with a peak-to-peak voltage Vp-p of 5 V and frequency of 1 kHz, the peak-to-peak voltage Vp-p of the voltage 53 input to the microcomputer 16 becomes 2.8 V, so that the voltage value is increased compared with the voltage 43 obtained during normal operation.

Hence when the voltage 42 at frequency fs is applied to the center point P3 by the signal generator 9, if the voltage 43 output from the differential voltage detection circuit 2 is outside a preset voltage judgment range, the microcomputer 16 judges that the common-mode noise immunity has declined.

Here, the frequency fs is set to a frequency, for example 1 kHz, within a frequency region A in which the amount of attenuation between input and output signals of the differential voltage detection circuit 2 changes with a change in frequency f of signals input to the input terminals IN1 and IN2 as indicated by the symbol A in Fig. 4B, that is, within the range of the frequency region A in which the voltage value obtained by the differential voltage detection circuit 2 changes with changes in the frequency f.

Further, as the voltage judgment range W, for example the range in which the peak-to-peak voltage Vp-p is within + 10% of the voltage Vp-p = 0.5 V of the voltage 43 obtained at the frequency fs during normal operation, that is, 0.5 V ≤ W ≤ 0.55 V.

Here, if the frequency fs is set in the region B in which the amount of attenuation between input and output signals of the differential voltage detection circuit 2 does not change with a change in frequency f, then even when some anomaly occurs in the differential voltage detection circuit 2, no change in the attenuation amount in the differential voltage detection circuit 2 appears, and so there is the concern that a decline in common-mode noise immunity cannot be detected; hence as the frequency fs, a frequency in the range of the frequency region A is appropriate.

### (Embodiment 2)

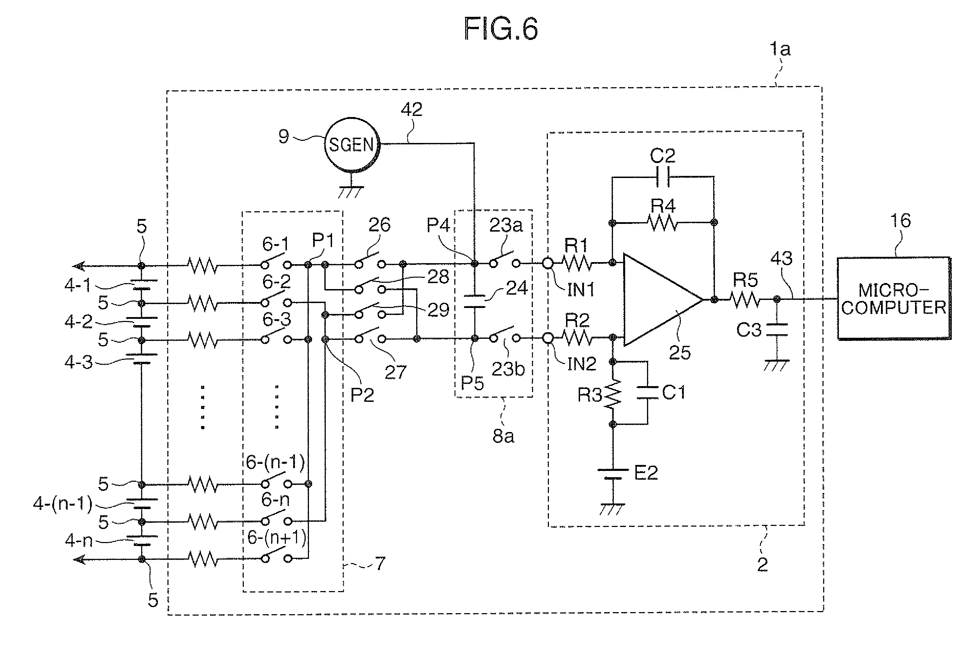

Fig. 6 is a circuit diagram showing another example of the configuration of a flying capacitor circuit added with a signal generation device in one embodiment of the invention. The voltage detection device 1a a shown in Fig. 6 is a device which detects the voltage of a secondary battery, in which a plurality of battery modules 4 are connected in series, and comprises a multiplexer 7 having a sampling switch 6; a flying capacitor circuit 8a; a differential voltage detection circuit 2; and a signal generator 9, which applies common-mode noise to the flying capacitor circuit 8a. The output of the differential voltage detection circuit 2 is input to a microcomputer 16.

The voltage detection device 1a shown in Fig. 6 differs from the voltage detection device 1 of Fig. 1 in comprising a capacitor 24 in place of the capacitors 24a, 24b in the flying capacitor circuit 8a, and in applying the output voltage 42 of the signal generator 9 to the connection point P4 of the capacitor 24 with the switch 23a in the flying capacitor circuit 8a.

Further, the voltage detection device 1a does not comprise a switch SW1. And, the voltage detection device 1a differs from the voltage detection device 1 in that a switch 26 is interposed between the connection point P1 and the connection point P4, a switch 27 is interposed between P5, which is the connection point between the capacitor 24 and the switch 23b, and the connection point P2, a switch 28 is interposed between the connection point P1 and the connection point P5, and a switch 29 is interposed between the connection point P2 and the connection point P4. Further, a constant-voltage supply E2 is used instead of the constant-voltage supply E1.

And, when measuring the terminal voltage of an odd-numbered battery module 4, the microcomputer 16 turns on the switches 26 and 27 and turns off the switches 28 and 29, and when measuring the terminal voltage of an even-numbered battery module 4, the microcomputer 16 turns off the switches 26 and 27 and turns on the switches 28 and 29; by this means, it can be ensured that the polarity of charging of the capacitor 24 is the same direction, regardless of whether the battery module 4 is odd-numbered or even-numbered.

Then, by either setting the output voltage of the constant-voltage supply E2 to 0 V (direct connection to ground), or, when the polarity of the differential amplification circuit 25 is opposite the charging direction of the capacitor 24, by setting the output voltage of the constant-voltage supply E2 to 5 V, the input voltage range of the analog/digital converter in the microcomputer 16 can be fully utilized.

Further, when the voltage 42 output from the signal generator 9 is applied to the connection point P4, this directly becomes common-mode noise, but as a result of common-mode conversion of a portion of the voltage 42 by the capacitor 24, pseudo-common-mode noise can be applied to the flying capacitor circuit 8a.

By this means, similarly to the voltage detection device 1 shown in Fig. 1, common-mode noise immunity performance of the differential amplification circuit comprised by the flying capacitor circuit can be diagnosed from the frequency dependence of the measured voltage by the microcomputer 16.

Voltage detection devices of the prior art generally performed malfunction diagnosis only of direct current characteristics, and so could not perform diagnoses including the effects on voltage detection precision due to changes in the voltage relative to ground of a secondary battery occurring due to changes in the floating capacitive coupling to ground of the load connected to the secondary battery, such as for example the windings in a motor, or due to changes in the floating capacitive coupling to ground of wires supplying power to a motor, or due to changes in the capacitance to ground of IGBTs or similar comprised by an inverter.

On the other hand, the voltage detection devices 1 and 1a shown in Fig. 1 and Fig. 6 can precisely detect declines in the common-mode noise immunity of the differential amplification circuit comprised by the flying capacitor circuit, and so concerns of erroneous detection of secondary battery malfunctions and similar due to a decline in detection precision can easily be alleviated.

That is, a voltage detection device according to one aspect of the invention comprises a differential voltage detection circuit, which detects the potential difference across a pair of input terminals; a multiplexer having a sampling switch, which selects two electrode terminals among the electrode terminals of a plurality of series-connected battery modules, and respectively connects the two selected electrode terminals to first and second wiring lines; a flying capacitor circuit, which acquires the voltage across the first and second wiring lines, and outputs the voltage to the pair of input terminals; and, a signal generator, which applies common-mode noise to the flying capacitor circuit.

By means of this configuration, common-mode noise can be applied to the flying capacitor circuit by the signal generator, so that based on the voltage detected by the differential voltage detection circuit when common-mode noise is applied, the common-mode noise immunity performance can easily be diagnosed.

Further, it is preferable that a judgment portion be comprised which executes judgment processing such that, when the common-mode noise is applied to the flying capacitor circuit by the signal generator, if the voltage detected by the differential voltage detection circuit is outside the preset voltage judgment range, a judgment that the common-mode noise immunity has declined be performed.

By means of this configuration, whether common-mode noise immunity has declined can be judged by the judgment portion.

Further, it is preferable that the frequency of the common-mode noise be set within the frequency region in which the voltage value obtained by the differential voltage detection circuit changes with changes in the frequency of the signal input to the pair of input terminals.

If the frequency of the common-mode noise applied by the signal generator is set in a region in which the voltage value obtained by the differential voltage detection circuit does not change with changes in the frequency of the signal input to the pair of input terminals, then no change in the attenuation amount in the differential voltage detection circuit appears even if some anomaly occurs in the differential voltage detection circuit, and therefore there are concerns that a decline in common-mode noise immunity cannot be detected; hence a frequency in the above-described frequency region is appropriate as the frequency of the common-mode noise.

Further, it is preferable that the flying capacitor circuit comprise two or more flying capacitors connected in series, that the series circuit of the plurality of flying capacitors be connected between a first wiring line and a second wiring line, and that the signal generator apply a signal having a preset frequency to a center point of the plurality of flying capacitors as common-mode noise.

By means of this configuration, the signal applied as common-mode noise to the center point of the plurality of flying capacitors by the signal generator is applied to the first wiring line and second wiring line with the plurality of flying capacitors, so that as a result of application by the flying capacitor circuit to the pair of input terminals of the differential voltage detection circuit of the common-mode noise appearing across the first wiring line and second wiring line, common-mode noise can be applied to the differential voltage detection circuit.

Further, it is preferable that the configuration further comprise a first switching element, which opens and closes the connection between the connection point between the flying capacitors and the first wiring line, and one among the pair of input terminals; a second switching element, which opens and closes the connection between the connection point between the flying capacitors and the second wiring line, and the other among the pair of input terminals; a third switching element, which opens and closes the connection between the center point and ground; and, a control portion, which, with the first, second, and third switching elements turned off, after connecting the first and second wiring lines to the two electrode terminals selected by the multiplexer and charging the plurality of flying capacitors, opens the connection of the multiplexer, and by turning on the first, second, and third switching elements, causes the voltage across the two selected electrode terminals to be detected by the differential voltage detection circuit.

By means of this configuration, with the first and second switching elements turned off and the flying capacitors detached from the differential voltage detection circuit, and with the third switching element turned off and the flying capacitors put into a floating state, the flying capacitors are connected to the two electrode terminals selected by the multiplexer and are charged, so that the voltage across the two electrode terminals to be detected can be used to charge the flying capacitors and held, without being affected by the difference between potential relative to ground of the battery module and potential relative to ground of the differential voltage detection circuit.

Next, by opening the connection of the multiplexer, the flying capacitors are detached from the battery module, and by turning on the first and second switching elements, the voltage held by the flying capacitors is supplied to the differential voltage detection circuit, and the voltage across two electrode terminals which is to be detected can be detected by the differential voltage detection circuit, without being affected by the potential difference, relative to ground, between the battery module and the differential voltage detection circuit. At this time, the third switching element is turned on, and the center point of the plurality of series-connected flying capacitors is connected to ground, so that as a result of arranging the potential relative to ground of the flying capacitors and the potential relative to ground of the differential voltage detection circuit, the input voltage range of the differential voltage detection circuit can be effectively utilized.

Further, the flying capacitor circuit may comprise a flying capacitor connected between the first wiring line and the second wiring line, and the signal generator may apply a signal having a preset frequency to the first wiring line, to cause the common-mode noise at the first and second wiring lines.

By means of this configuration, the periodic signal applied to the first wiring line by the signal generator is also applied to the second wiring line via the flying capacitor, as a result of which common-mode noise can be caused in the first and second wiring lines. By this means, common-mode noise can be applied to the differential voltage detection circuit.

Further, it is preferable that the configuration further comprise a first switching element, which opens and closes the connection between the connection point between the flying capacitor and the first wiring line, and one among the pair of input terminals; a second switching element, which opens and closes the connection between the connection point between the flying capacitor and the second wiring line, and the other among the pair of input terminals; and, a control portion, which, with the first and second switches turned off, after connecting the two electrode terminals selected by the multiplexer to the first and second wiring lines respectively and charging the flying capacitor, opens the connection of the multiplexer, and by turning on the first and second switching elements, causes the differential voltage detection circuit to detect the voltage across the selected two electrode terminals.

By means of this configuration, with the first and second switching elements turned off and the flying capacitors detached from the differential voltage detection circuit, the flying capacitors are connected to and charged by the two electrode terminals selected by the multiplexer, so that the flying capacitors can be charged by and can hold the voltage across the two electrode terminals to be detected, without being affected by the difference between potential relative to ground of the battery module and potential relative to ground of the differential voltage detection circuit.

Next, by opening the connection of the multiplexer, the battery module is detached from the flying capacitors, and the first and second switching elements are turned on, to supply the voltage held by the flying capacitors to the differential voltage detection circuit; by this means the voltage across the two electrode terminals to be detected can be detected by the differential voltage detection circuit, without being affected by the difference between potential relative to ground of the battery module and potential relative to ground of the differential voltage detection circuit.

Further, the power supply system of one aspect of the invention comprises an above-described voltage detection device, and a plurality of battery modules.

By means of this configuration, in the power supply system comprising the plurality of battery modules and the voltage detection device using flying capacitors, diagnosis of the common-mode noise immunity performance is possible.

### Industrial Applicability

A voltage detection device of this invention employs a flying capacitor circuit which detects the voltage of an insulated secondary battery group, and can be appropriately used in diagnostics of malfunctions in the voltage detection circuit of a power supply system which in particular drives the motor of an electric vehicle, hybrid elevator, or similar.

## Claims

1. A voltage detection device, comprising:
a differential voltage detection circuit, which detects a potential difference across a pair of input terminals;
a multiplexer which selects two electrode terminals among electrode terminals of a plurality of series-connected battery modules, and has a sampling switch for respectively connecting the two selected electrode terminals to first and second wiring lines;
a flying capacitor circuit, which acquires a voltage across the first and second wiring lines, and outputs the voltage to the pair of input terminals; and
a signal generator, which applies common-mode noise to the flying capacitor circuit.

2. The voltage detection device according to Claim 1, further comprising a judgment portion which, when the common-mode noise is applied to the flying capacitor circuit by the signal generator, in a case where the voltage detected by the differential voltage detection circuit is outside a preset voltage judgment range, judges that the common-mode noise immunity has declined.

3. The voltage detection device according to Claim 2, wherein a frequency of the common-mode noise is set in a frequency region in which a voltage value obtained by the differential voltage detection circuit changes in accordance with a change in a frequency of the signal input to the pair of input terminals.

4. The voltage detection device according to any one of Claims 1 through 3, wherein
the flying capacitor circuit comprises two or more flying capacitors connected in series,
a series circuit of the plurality of flying capacitors is connected between the first wiring line and the second wiring line, and
the signal generator applies a signal having a preset frequency to a center point of the plurality of flying capacitors as the common-mode noise.

5. The voltage detection device according to Claim 4, further comprising:
a first switching element, which opens and closes a connection between a connection point between the flying capacitors and the first wiring line, and one of the pair of input terminals;
a second switching element, which opens and closes a connection between a connection point between the flying capacitors and the second wiring line, and the other of the pair of input terminals;
a third switching element, which opens and closes a connection between the center point and ground; and
a control portion, which, with the first, second, and third switching elements turned off, after connecting the two electrode terminals selected by the multiplexer to the first and second wiring lines respectively and charging the plurality of flying capacitors, opens the connection of the multiplexer, and by turning on the first, second, and third switching elements, causes the voltage across the two selected electrode terminals to be detected by the differential voltage detection circuit.

6. The voltage detection device according to any one of Claims 1 through 3, wherein
the flying capacitor circuit comprises a flying capacitor connected between the first wiring line and the second wiring line, and
the signal generator supplies a signal having a preset frequency to the first wiring line to cause the common-mode noise in the first and second wiring line.

7. The voltage detection device according to Claim 6, further comprising:
a first switching element, which opens and closes the connection between the connection point between the flying capacitor and the first wiring line, and one of the pair of input terminals;
a second switching element, which opens and closes the connection between the connection point between the flying capacitor and the second wiring line, and the other of the pair of input terminals; and
a control portion, which, with the first and second switching elements turned off, after connecting the two electrode terminals selected by the multiplexer to the first and second wiring lines respectively and charging the flying capacitor, opens the connection of the multiplexer, and by turning on the first and second switching elements, causes the differential voltage detection circuit to detect the voltage across the selected two electrode terminals.

8. A power supply system, comprising:
the voltage detection device according to any one of Claims 1 through 7; and,
the plurality of battery modules.
